# EUROPEAN PATENT SPECIFICATION

(11) **EP 1 801 899 B1**
(45) Date of publication and mention of the grant of the patent: **05.12.2012**
(21) Application number: 06256465.3
(22) Date of filing: 20.12.2006
(51) Int. Cl.: H01L 51/50, H01L 51/00

(54) **Organic electroluminescent display device and method of preparing the same**
Organische Elektrolumineszenzanzeigevorrichtung und Herstellungsverfahren dafür
Dispositif d'affichage électroluminescent organique et son procédé de préparation

(30) Priority: 20.12.2005 KR 20050126102
(43) Date of publication of application: 27.06.2007
(73) Proprietor: Samsung Display Co., Ltd., Yongin-City, Gyeonggi-Do (KR)
(72) Inventor: Chun, Min-Seung, c/o Y.P.Lee, Mock & Partners., Seocho-Gu, Seoul (KR); Kim, Mi-Kyung, c/oSamsung SDI Co., Ltd., Gyeonggi-do (KR); Kim, Dong-Hun, c/o Y.P.Lee, Mock & Partners, Seocho-Gu, Seoul (KR); Son, Jung-Ha, c/oSamsung SDI Co., Ltd., Gyeonggi-do (KR); Kwak, Jae-Hyun, c/oSamsung SDI Co., Ltd., Gyeonggi-do (KR)
(74) Representative: Mounteney, Simon James

(56) References cited:
- EP-A2- 1 052 708
- EP-A2- 1 531 501
- US-A1- 2005 260 451

## Description

### BACKGROUND

### Field

The present invention relates to an organic electroluminescent (EL) display device and a method of manufacturing the same, and more particularly, to an organic EL display device having a charge generation layer between a hole injection layer and a hole transport layer and a method of manufacturing the same.

### Description of the Related Technology

Electroluminescent (EL) devices, which are self light emitting display devices, have a wide viewing angle, excellent contrast and quick response time. EL devices are classified into inorganic EL devices and organic EL devices depending on the materials used to form emitting layers. Organic EL devices are brighter than inorganic EL devices. In addition, organic EL devices have lower driving voltages and quicker response time than inorganic EL devices. Furthermore, organic EL devices clan generate multiple colors. EP1531501 and US2005/0260451 both disclose organic EL devices.

Typically, an organic EL display device includes an anode formed over a substrate. A hole transport layer (HTL), an light-emitting layer (EML), an electron transport layer (ETL) and a cathode are stacked sequentially over the HTL. The HTL, EML and ETL are organic thin films formed of organic compounds.

When a voltage is applied between the anode and cathode of an organic EL device, holes injected from the anode are transported to the EML through the HTL. On the other hand, electrons injected from the cathode are transported to the EML though the ETL. Then, excitons are generated by a recombination of the holes and electrons in the EML. The excitons, while returning to their ground state, make fluorescent molecules of the EML emit light to form an image.

For top emission organic EL display devices, as the device profile becomes thicker, the microcavity effect increases and emission defects due to impurities decrease. The microcavity effect refers to a variation in a wavelength of light emitting from an EL display device according to a path along which the light travels.

However, a thick profile device may have a high driving voltage. To maximize efficiency, an optimal path needs to be set to emit light having a wavelength close to the original wavelength of the light. The path can be set by regulating the thicknesses of organic layers of the device. Typically, light having a longer wavelength tends to be obtained when a thicker organic layer is used. That is, red light is obtained by using thicker organic layers while blue light is obtained by using thinner organic layers. Therefore, an optimal range of thickness for an organic layer may be determined based on the desired wavelength of light. The range of the thickness has a preferable period thickness and thus a maximum light extraction efficiency can be obtained. A one-period thickness may be too thin to prevent emission defects due to particles. A two-period thickness may be too thick to prevent an increase in the driving voltage even though the two-period thickness may prevent emission defects due to particles.

### SUMMARY

According to a first aspect of the invention there is provided an organic electroluminescent (EL) display device as set out in claim 1. Preferred features are set out in claims 2 to 10.

A second aspect of the invention provides an electronic device comprising an organic EL display device as set out in claims 1-11.

A third aspect of the invention provides a method of manufacturing an organic EL display device as set out in claim 12. Preferred features are set out in claims 13 to 17.

### BRIEF DESCRIPTION OF THE DRAWINGS

The above and other features and advantages of the instant disclosure will become more apparent by describing in detail embodiments thereof with reference to the attached drawings in which:

FIG. 1 is; a cross-sectional view of an organic electroluminescent (EL) display device; and

FIGS. 2A through 2C are cross-sectional views of organic EL display devices according to embodiments of the invention.

### DETAILED DESCRIPTION

Hereinafter, the embodiments of the invention will be described more fully with reference to the accompanying drawings.

An organic electroluminescent (EL) display device according to an embodiment includes a first electrode and a second electrode. The device also includes a light-emitting layer (EML) between the first and second electrodes. The device further includes a hole injection layer (HIL) and a hole transport layer (HTL) between the first electrode and the EML- In addition, the device includes a charge generation layer interposed directly on the HIL and wherein the HTL is on the charge generation layer.

The charge generation layer includes a compound represented by Formula 1 below:

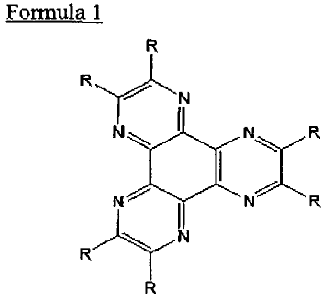

In Formula 1, R is a nitrile group (-CN), a sulfone group (-SO₂R'), a sulfoxide group (-SOR'), a sulfonamide group (-SO₂NR'₂), a sulfonate group (-SO₃R'), a nitro group (-NO₂), or a trifluoromethyl group (-CF₃). Also, R' is a C₁-C₆₀ alkyl group, a C₆-C₆₀ aryl group, or a C₁-C₆₀ heterocyclic group, which are unsubstituted or substituted with an amine, an amide, an ether, or an ester.

Examples of compounds of Formula 1 includes, but are not limited to the following compounds:

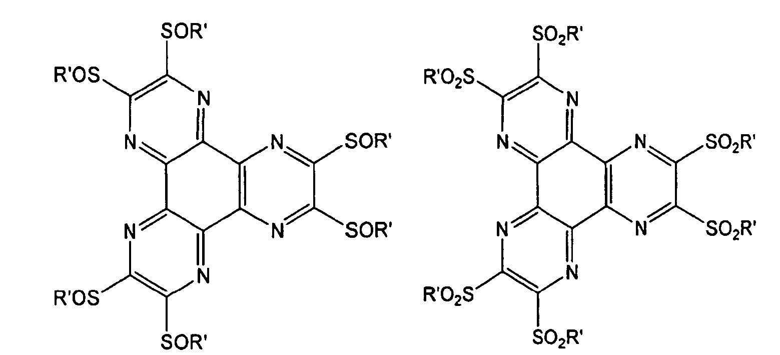

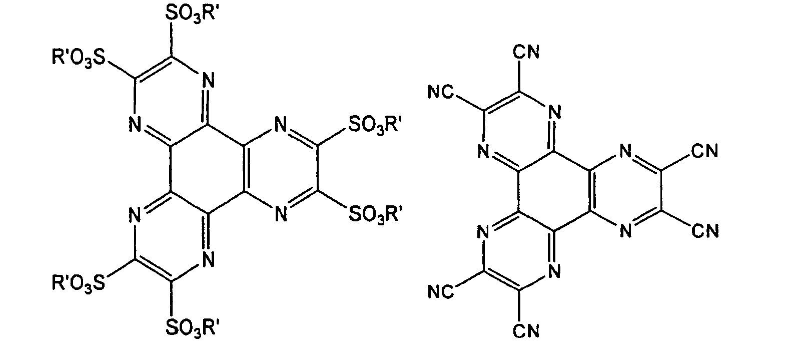

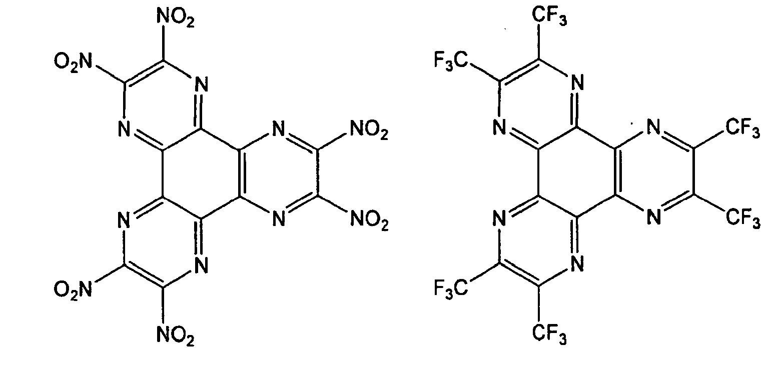

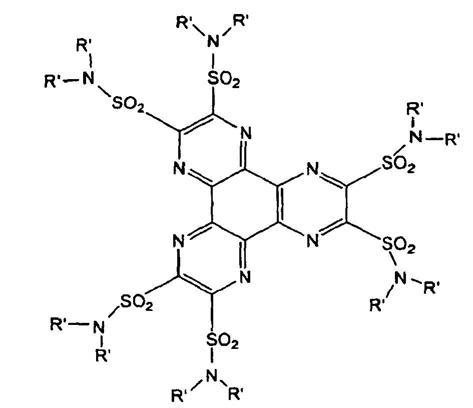

In the above examples, R' is a C₁-C₆₀ alkyl group, a C₆-C₆₀ aryl group, or a C₁-C₆₀ heterocyclic group, which is unsubstituted or substituted with an amine, an amide, an ether, or an ester. The organic materials represented by the formulae above are for illustrative purposes only, and the invention is not limited to the formulae.

A difference between the lowest unoccupied molecular orbital (LUMO) energy level of a material for the charge generation layer and the highest occupied molecular orbital (HOMO) energy level of a material for the HIL may be in a range of about -2 eV to about +2 eV. For example, hexa-azatriphenylene (non-inventive material) has a HOMO energy level of about 9.6 to 9.7 eV and a LUMO energy level of about 5.5 eV. The average HOMO energy level of a material for the HIL in an organic EL device is in a range of about 4.5 to about 5.5 eV. Accordingly, when hexa-azatriphenylene is used for the charge generation layer, a difference between the LUMO energy level of the charge generation layer and the HOMO energy level of the HIL may range from about 0 eV to about 1.0 eV. The driving voltage can be reduced by the charge generation layer formed between the HIL and the HTL.

The charge generation layer can be formed using any suitable method. Examples of such methods include, but are not limited to: resistance heating vapor deposition, electron beam vapor deposition, laser beam vapor deposition and sputtering deposition. When the charge generation layer is formed of the compound represented by Formula 1 in which R' is a C₅-C₆₀ alkyl group which is unsubstituted or substituted with an amine, an amide, an ether, or an ester, the charge generation layer can be formed by a process using a solution, such as inkjet printing, spin-coating, doctor-blading, roll coating, etc., instead of deposition. The charge generation layer can be formed as a common layer for all pixels. The thickness of the charge generation layer can be in a range of from about 10Å to about 200Å, optionally in a range of from about 20Å to about 80Å (10Å = 1 nm). When the thickness of the charge generation layer is less than 10Å, charge generation is low, and when the thickness of the charge generation layer is greater than 200Å, the driving voltage is high and the possibility of cross-talk due to a leakage current arises.

The organic EL display device may further include at least one of a hole blocking layer (HBL), an electron transport layer (ETL) and an electron injection layer (EIL) between the EML and the second electrode.

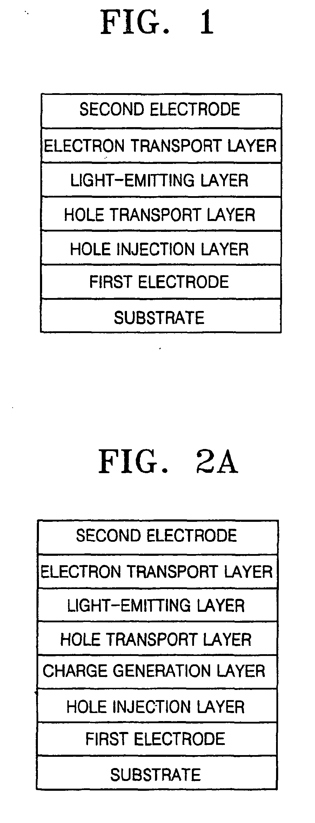

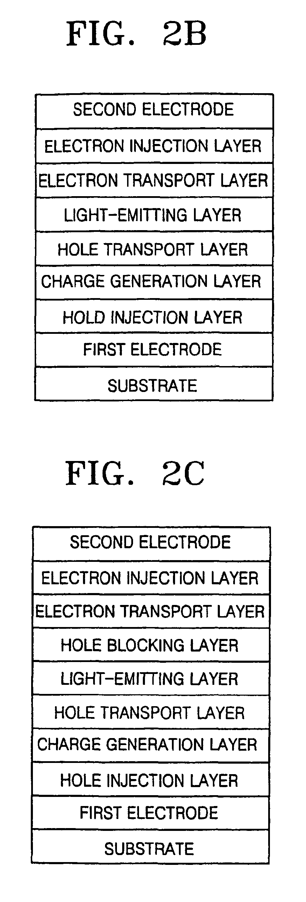

A method of manufacturing an organic EL display device which includes an EML between a first and a second electrode according to an embodiment includes forming a HIL on the first electrode, forming a charge generation layer on the HIL, and forming a HTL on the charge generation layer. The method of manufacturing the organic EL display device according to an embodiment will be described in detail with reference to FIGS. 2A through 2C.

First, an anode (a first electrode) may be formed on a substrate. The substrate can be any substrate suitable for an organic EL display device. The substrate may be formed of glass or a plastic material. The plastic material may have excellent transparency and surface smoothness. The plastic material may be easily processed and may be water-proof. The anode can be formed of a high work function metal (≥ about 4.5 eV), such as indium tin oxide (ITO), indium zinc oxide (IZO), tin oxide (SnO₂), zinc oxide (ZnO), or any suitable transparent material which has high conductivity.

Then, an HIL can be formed on the anode using high vacuum thermal evaporation deposition. Depending on the type of material used to form the HIL, the HIL can also be formed using a solution containing the material by spin-coating, dip-coating, doctor-blading, inkjet printing, thermal transfer, organic vapor phase deposition (OVPD), etc.

The HIL may be formed by one of the methods described above such as vacuum thermal deposition, spin-coating, etc. The thickness of the HIL can be in a range of from about 100Å to about 2500Å. When the thickness of the HIL is less than 100Å, the hole injecting ability is low, and when the thickness of the HIL is greater than 2500Å, the driving voltage is high. In one embodiment for a top emission structure device, the thickness of the HIL may be in a range of from about 1000 Å to about 2500 Å. A skilled artisan will appreciate that the thickness may vary depending on the color of light which the device emits.

Examples of the material used to form the HIL include, but are not limited to, copper phthalocyanin (CuPc) or a starbust type amine such as TCTA, m-MTDATA or IDE406 (available from Idemitsu Kosan Co., Ltd., Tokyo, Japan). Below are formulas of CuPc, TCTA, and m-MTDATA.

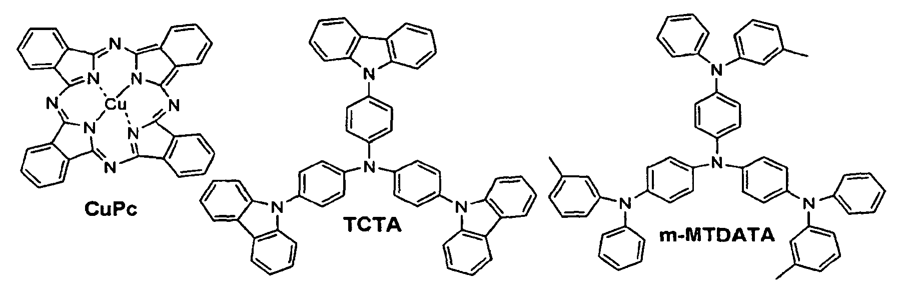

A charge generation layer is formed directly on the HIL. The material for the charge generation layer includes compounds represented by Formula 1 below:

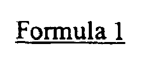

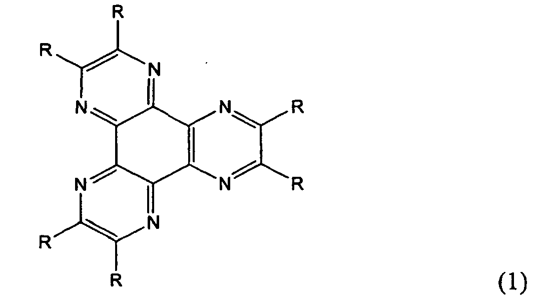

In Formula 1, R is a nitrile group (-CN), a sulfone group (-SO₂R'), a sulfoxide group (-SOR'), a sulfonamide group (-SO₂NR'₂), a sulfonate group (-SO₃R'), a nitro group (-NO₂), or a trifluoromethyl group (-CF₃). Also, R' is a C₁-C₆₀ alkyl group, a C₆-C₆₀ aryl group, or a C₁-C₆₀ heterocyclic group, which is unsubstituted or substituted with an amine, an amide, an ether, or an ester.

The charge generation layer can be formed on the HIL using resistance heating vapor deposition, electron beam vapor deposition, laser beam vapor deposition or sputtering. The charge generation layer can be formed as a common layer for all pixels. The thickness of the charge generation layer can be about 10Å to about 200Å, optionally about 20 to about 80Å. When the thickness of the charge generation layer is less than 10Å, charge generation is low, and when the thickness of the charge generation layer is greater than 200Å, the driving voltage is high and the possibility of cross-talk due to a leakage current arises.

The HTL may be formed on the charge generation layer using various processes such as vacuum thermal deposition or spin-coating. The material that is used to form the HTL is not limited. Examples of the material include N,N'-bis(3-methylphenyl)- N,N'-diphenyl-[1,1-biphenyl]-4,4'-diamine (TPD), N,N'-di(naphthalene-1-il)-N,N'-diphenyl benzidine (α -NPD), and IDE 320 (available from Idemitsu Kosan Co., Ltd.). The thickness of the HTL can be about 50Å to about 1500Å. When the thickness of the HTL is less than 50Å, the hole transporting ability is low, and when the thickness of the HTL is higher than 1500Å, the driving voltage is high. The chemical formulas of TPD and α -NPD are as follows:

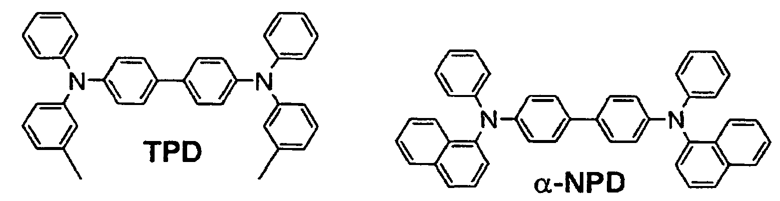

An EML is formed on the HTL. The process of forming the EML is not limited. Various processes such as vacuum deposition, inkjet printing, laser printing, photolithography and OVPD can be used. The thickness of the EML can be about 100Å to about 800Å.

When the thickness of the EML is less than 100Å, the efficiency and lifespan of the organic EL display device are low, and when the thickness of EML is greater than 800Å, the driving voltage is high. A hole blocking layer (HBL) may be selectively formed on the EML by one of the methods described above such as vacuum deposition, spin-coating, etc. The material that is used to form the HBL is not limited. The material is capable of transporting electrons and have a higher ionization potential than the light-emitting compound. Examples of the material for the HBL include Balq, BCP and TPBI. The thickness of the HBL can be in a range of from about 30Å to about 500Å. When the thickness of HBL is less than 30Å, efficiency decreases due to a poor hole blocking ability, and when the thickness of the HBL is greater than 500Å, the driving voltage is high. The chemical formulas of Balq, BCP and TPBI are as follows:

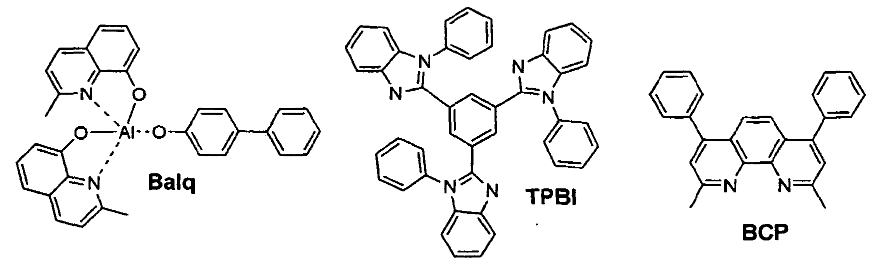

An electron transport layer (ETL) may be formed on the HBL using vacuum deposition or spin-coating. The material that is used to form the ETL is not limited, and may be Alq3. The thickness of the ETL can be about 50Å to about 600Å. When the thickness is less than 50Å, the lifespan of the organic EL display device is low, and when the thickness is greater than 600Å, the driving voltage is high.

An EIL may be selectively formed on the ETL. The material that is used to form the EIL can be LiF, NaCl, CsF, Li₂O, BaO or Liq. The thickness of the EIL can be in a range of from about 1 Å to about 100Å. Below is the chemical formula of Liq. When the thickness of EIL is less than 1Å, the EIL can not perform its function properly, and when the thickness of the EIL is greater than 100Å, the driving voltage is high since the EIL functions as a insulation layer.

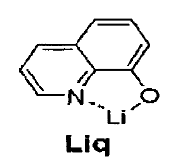

A cathode (a second electrode) may be formed on the EIL using one of vacuum thermal deposition, sputtering, metal-organic chemical vapor deposition, etc., thereby completing the organic EL display device. The metal used for the cathode can be Li, Mg, Al, Al-Li, Ca, Mg-In or Mg-Ag.

The organic EL display device according to claim 1 may further include one or two intermediate layers between two of the anode, the HIL, the charge generation layer, the HTL, the EML, the ETL, the EIL and the cathode. In addition, an HBL and an electron blocking layer (EBL) can further be included in the organic EL display device.

Hereinafter, embodiments of the invention will be described in more detail with reference to the following examples. The following examples are for illustrative purposes, and thus are not intended to limit the scope of the invention.

### Example 1

A 15Ω /cm² (1200Å) ITO glass substrate manufactured by Coming Inc. (Coming, NY) was cut into pieces of 50mm x 50mm x 0.7mm in size, and each piece was ultrasonically cleaned in isopropyl alcohol and deionized water for 5 minutes and then UV/ozone cleaned for 30 minutes to form an anode.

M-MTDATA was vacuum deposited on the substrate to form an HIL with a thickness of 500Å. Hexa-azatriphenylene (non-inventive material) was resistance-heating deposited on the HIL to form a charge generation layer with a thickness of 20Å. N,N'-di(1-naphthyl)-N,N'-diphenyl benzidine(α -NPD) was vacuum deposited on the charge generation layer to form the hole transport layer with a thickness of 200Å.

Vacuum deposition using organic vapor phase deposition (OVPD) was performed to form an EML with a thickness of about 300Å. Alq3 as an electron transporting material was deposited on the EML to form an ETL with a thickness of about 300Å. LiF was vacuum deposited on the electron transport layer to form an EIL with a thickness of 10Å on the ETL and an Mg-Ag alloy was vacuum deposited on the EIL to form a cathode with a thickness of 200Å, thereby completing an organic EL display device.

### Example 2

An organic EL display device was manufactured in the same manner as in Example 1, except that the thickness of the charge generation layer was 50Å.

### Example 3

An organic EL display device was manufactured in the same manner as in Example 1, except that the thickness of the charge generation layer was 80Å.

### Comparative Example 1

A 15Ω /cm² (1200Å) ITO glass substrate manufactured by Coming Inc. was cut into pieces of 50mm x 50mm x 0.7mm in size, and each piece was ultrasonically cleaned in isopropyl alcohol and deionized water for 5 minutes and then UV/ozone cleaned for 30 minutes to form an anode.

M-MTDATA was vacuum deposited on the substrate to form an HIL with a thickness of 1300Å. N,N'-di(1-naphthyl)-N,N'-diphenyl benzidine(α -NPD) was vacuum deposited on the HIL to form an HTL with a thickness of 200Å.

Vacuum deposition using OVPD was performed to form an EML with a thickness of about 300Å. Alq3 as an electron transporting substance was deposited on the EML to form an ETL with a thickness of about 300Å. LiF was vacuum deposited on the ETL to form an EIL with a thickness of 10Å, and an Mg-Ag alloy was vacuum deposited on the EIL to form a cathode with a thickness of 200Å, thereby completing an organic EL display device.

The driving voltages, efficiencies and lifespans of the organic EL display devices manufactured according to Examples 1 through 3 and Comparative Example 1 were measured. The results are shown in Table 1.

**Table 1**

| | Driving voltage (V) | Efficiency (cd/V) | Lifespan (hour) |
|---|---|---|---|
| Example 1 | 5.50 | 3.16 | 1,500 |
| Example 2 | 5.31 | 3.57 | 1,500 |
| Example 3 | 5.22 | 4.16 | 1,500 |
| Comparative Example 1 | 6.08 | 3.04 | 1,000 |

The driving voltages of the organic EL devices obtained in Examples 1 through 3 were in the range of 5.50 to 5.22 V, and the driving voltage of the EL device obtained in Comparative Example 1 was 6.08 V.

The efficiencies of the organic EL devices obtained in Examples 1 through 3 were in the range of 3.16 to 4.16 cd/A at a brightness of 400 cd/m². The efficiency of the organic EL device obtained in Comparative Example 1 was 3.04 cd/A at a brightness of 400 cd/m².

The lifespan indicates time taken for a brightness to decrease to 50% of the initial brightness. The lifespans of the organic EL display devices obtained in Examples 1 through 3 were about 1,500 hours at 5,000 cd/m², and the lifespan of the organic EL display device obtained in Comparative Example 1 was 1,000 hours at 5,000 cd/m². Accordingly, the lifespan of the organic EL display device of Example 1 was than 1.5 times longer than the lifespan of the organic EL display device of Comparative Example 1.

The organic EL display device of the embodiments has the charge generation layer between the HIL and the HTL, and thus, the driving voltage of the EL display device is low, and the efficiency of the EL display device is high, and the lifespan of the organic EL display device is long.

## Claims

1. An organic electroluminescent (EL) display device comprising:
a first electrode;
a second electrode;
a light-emitting layer interposed between the first electrode and the second electrode;
a hole injection layer interposed between the first electrode and the light-emitting layer,
a hole transport layer interposed between the hole injection layer and the light-emitting layer: and
a charge generation layer interposed between the hole injection layer and the hole transport layer, wherein the charge generation layer is directly on the hole injection layer; **characterized in that** the charge generation layer is formed of a compound represented by Formula 1 below: 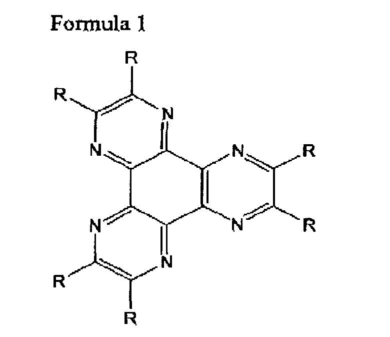
wherein R is selected from the group consisting of a nitrile group (-CN), a sulfone group (-SO₂R'), a sulfoxide group (-SOR'), a sulfonamide group (-SO₂NR'₂), a sulfonate group (-SO₃R'), a nitro group (-NO₂), and a trifluoromethyl group (-CF₃); and
wherein R' is selected from the group consisting of a C₁-C₆₀ alkyl group, a C₆-C₆₀ aryl group, and a C₁C₆₀ heterocyclic group which are unsubstituted or substituted with an amine, an amide, an ether, or an ester.

2. An organic EL display device according to claim 1, wherein the charge generation layer comprises a first material having a lowest unoccupied molecular orbital energy level, wherein the hole injection layer comprises a second material having a highest occupied molecular orbital energy level, and wherein a difference between the lowest unoccupied molecular orbital energy level of the first material and the highest occupied molecular orbital energy level of the second material is in a range of about -2 eV to about +2 eV.

3. An organic EL display device according to any preceding claim, wherein the device comprises a plurality of pixels, and wherein the charge generation layer forms a common layer for at least two of the pixels.

4. An organic EL display device according to any preceding claim, wherein the charge generation layer has a thickness in a range of from about 1 nm (10 Å) to about 20 nm (200 Å).

5. An organic EL display device according to Claim 4, wherein the charge generation layer has a thickness in a range of from about 2 nm (20 Å) to about 8 nm (80 Å).

6. An organic EL display device according to any preceding claim, further comprising at least one layer selected from the group consisting of a hole blocking layer, an electron transport layer and an electron injection layer interposed between the light-emitting layer and the second electrode.

7. An organic EL display device according to any preceding claim, further comprising an electron transport layer interposed between the second electrode and the light-emitting layer.

8. An organic EL display device according to any preceding claim, further comprising a substrate, wherein the first electrode is formed over the substrate.

9. An organic EL display device of Claim 7 or 8, further comprising an electron injection layer interposed between the electron transport layer and the second electrode.

10. An organic EL display device of any one of Claims 7 or 9, further comprising a hole blocking layer interposed between the electron transport layer and the light emitting layer.

11. An electronic device comprising an organic EL display device according to any preceding claim.

12. A method of manufacturing an organic EL display device as claimed in claim 1, the method comprising:
forming a hole injection layer over a first electrode;
forming a charge generation layer over the hole injection layer; and
forming a hole transport layer over the charge generation layer.

13. A method according to Claim 12, further comprising:
forming a light-emitting layer over the hole transport layer, and
forming a second electrode over the light-emitting layer.

14. A method according to Claim 13, further comprising forming at least one of a hole blocking layer, an electron transport layer and an electron injection layer after forming the light-emitting layer and before forming the second electrode.

15. A method according to any one of claims 12 to 14, wherein the charge generation layer comprises a first material having a lowest unoccupied molecular orbital energy level, wherein the hole injection layer comprises a second material having a highest occupied molecular orbital energy level, and wherein a difference between the lowest unoccupied molecular orbital energy level of the first material and the highest occupied molecular orbital energy level of the second material is in a range of about -2 eV to about +2 eV.

16. A method according to any one of claims 12 to 15, wherein forming the charge generation layer comprises using resistance heating vapor deposition, electron beam vapor deposition, laser beam vapor deposition or spluttering deposition.

17. A method of any one of claims 12 to 16, wherein the charge generation layer has a thickness in a range of from about 1 nm (10 Å) to about 20 nm (200 Å).

## Patentansprüche

1. Organische elektrolumineszente (EL-) Anzeigevorrichtung, umfassend:
eine erste Elektrode,
eine zweite Elektrode,
eine lichtemittierende Schicht, die zwischen der ersten Elektrode und der zweiten Elektrode angeordnet ist,
eine Lochinjektionsschicht, die zwischen der ersten Elektrode und der lichtemitrierenden Schicht angeordnet ist,
eine Lochtransportschicht, die zwischen der Lochinjektionsschicht und der lichtemittierenden Schicht angeordnet ist, und
eine Ladungserzeugungsschicht, die zwischen der Lochinjektionsschicht und der Lochtransportschicht angeordnet ist, wobei die Ladungserzeugungsschicht direkt auf der Lochinjektionsschicht vorgesehen ist; **dadurch gekennzeichnet, dass** die Ladungserzeugungsschicht aus einer Verbindung der folgenden Formel I gebildet ist: 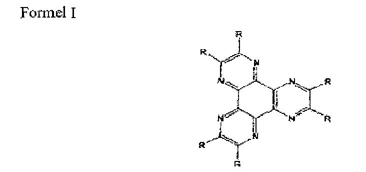
wobei R aus der Gruppe bestehend aus einer Nitrilgruppe (-CN), einer Sulfongruppe (-SO₂R'), einer Sulfoxidgruppe (-SOR'), einer Sulfonamidgruppe (-SO₂NR'₂), einer Sulfonatgruppe (-SO₃R'), einer Nitrogruppe (-NO₂) und einer Trifluormethylgruppe (-CF₃) ausgewählt ist; und
wobei R' aus der Gruppe bestehend aus einer C₁-C₆₀-Alkylgruppe, einer C₆-C₆₀-Arylgruppe und einer C₁-C₆₀-heterocyclischen Gruppe ausgewählt ist, die unsubstituiert oder mit einem Amin, einem Amid, einem Ether oder einem Ester substituiert sind.

2. Organische EL-Anzeigevorrichtung nach Anspruch 1, wobei die Ladungserzeugungsschicht ein erstes Material mit seinem LUMO-Energieniveau umfasst, wobei die Lochinjektionsschicht ein zweites Material mit einem HUMO-Energieniveau umfasst, und wobei ein Unterschied zwischen dem LUMO-Energieniveau des ersten Materials und dem HUMO-Energieniveau des zweiten Materials im Bereich von ungefähr -2 eV bis ungefähr +2 eV liegt.

3. Organische EL-Anzeigevorrichtung nach einem vorstehenden Anspruch, wobei die Vorrichtung eine Mehrzahl von Pixeln umfasst, und wobei die Ladungserzeugungsschicht eine gemeinsame Schicht für zumindest zwei der Pixel bildet.

4. Organische EL-Anzeigevorrichtung nach einem vorstehenden Anspruch, wobei die Ladungserzeugungsschicht eine Dicke im Bereich von ungefähr 1 nm (10 Å) bis ungefähr 20 nm (200 Å) aufweist.

5. Organische EL-Anzeigevorrichtung nach Anspruch 4, wobei die Ladungserzeugungsschicht eine Dicke im Bereich von ungefähr 2 nm (20 Å) bis ungefähr 8 nm (80 Å) aufweist.

6. Organische EL-Anzeigevorrichtung nach einem vorstehenden Anspruch, ferner umfassend zumindest eine Schicht, ausgewählt aus der Gruppe bestehend aus einer Lochblockierschicht, einen Elektronentransportschicht und einer Elektroneninjektionsschicht, angeordnet zwischen der lichtemittierenden Schicht und der zweiten Elektrode.

7. Organische EL-Anzeigevotrichtung nach einem vorstehenden Anspruch, ferner umfassend eine Elektronentransportschicht, die zwischen der zweiten Elektrode und der lichtemittierenden Schicht angeordnet ist

8. Organische EL-Anzeigevorrichtung nach einem vorstehenden Anspruch, ferner umfassend ein Substrat, wobei die erste Elektrode über dem Substrat gebildet ist.

9. Organische EL-Anzeigevorrichtung nach Anspruch 7 oder 8, ferner umfassend eine Elektroneninjektionsschicht, die zwischen der Elektronentransportschicht und der zweiten Elektrode angeordnet ist.

10. Organische EL-Anzeigevorrichtung nach einem der Ansprüche 7 bis 9, ferner umfassend eine Lochblockierschicht, die zwischen der Elektronentransportschicht und der lichtermittierenden Schicht angeordnet ist.

11. Elektronische Vorrichtung, umfassend eine organische EL-Anzeigevorrichtung nach einem vorstehenden Anspruch.

12. Verfahren zum Herstellen einer organischen EL-Anzeigevorrichtung nach Anspruch 1, wobei das Verfahren umfasst:
Bilden einer Lochinjektionsschicht über einer ersten Elektrode;
Bilden einer Ladungserzeugungsschicht über der Locbinjektionsschicht; und
Bilden einer Lochtransportschicht über der Ladungserzeugungsschicht.

13. Verfahren nach Anspruch 12, ferner umfassend:
Bilden einer lichtemittierenden Schicht über der Lochtransportschicht; und
Bilden einer zweiten Elektrode über der lichtemittierenden Schicht.

14. Verfahren nach Anspruch 13, ferner umfassend das Bilden von zumindest einem von einer Lochblockierschicht, einer Elektronentransportschicht und einer Elektroneninjektionsschicht nach dem Bilden der lichtemittierenden Schicht und vor dem Bilden der zweiten Elektrode.

15. Verfahren nach einem der Ansprüche 12 bis 14, wobei die Ladungserzeugungsschicht ein erstes Material mit einem LUMO-Enezgieniveau umfasst, wobei die Lochinjektionsschicht ein zweites Material mit einem HUMO-Energieniveau umfasst, und wobei ein Unterschied zwischen dem LUMO-Energieniveau des ersten Materials und dem HUMO-Energieniveau des zweiten Materials im Bereich von ungefähr -2 eV bis ungefähr+2 eV liegt.

16. Verfahren nach einem der Ansprüche 12 bis 15, wobei das Bilden der Ladungserzeugungsschicht das Verwenden von Wärmewiderstand-Dampfabscheidung, Elektronenstrahl-Dampfabscheidung, Laserstrahl-Dampfabscheidung oder Sputter-Abscheidung umfasst.

17. Verfahren nach einem der Ansprüche 12 bis 16, wobei die Ladungserzeugungsschicht eine Dicke im Bereich von ungefähr 1 nm (10 Å) bis ungefähr 20 nm (200 Å) aufweist.

## Revendications

1. Dispositif d'affichage électroluminescent (EL) organique comprenant :
une première électrode ;
une deuxième électrode ;
une couche luminescente interposée entre la première électrode et la deuxième électrode ;
une couche d'injection de trous interposée entre la première électrode et la couche luminescente ;
une couche de transport de trous interposée entre la couche d'injection de trous et la couche luminescente ; et
une couche de génération de charge interposée entre la couche d'injection de trous et la couche de transport de trous, la couche de génération de charge étant directement sur la couche d'injection de trous ; **caractérisé en ce que** la couche de génération de charge est formée d'un composé représenté par la formule 1 ci-dessous : 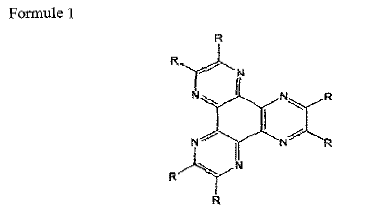
dans laquelle R est choisi dans l'ensemble constitué par un groupe nitrile (-CN), un groupe sulfone (-SO₂R'), un groupe sulfoxyde (-SOR'), un groupe sulfonamide (-SO₂NR'₂), un groupe sulfonate (-SO₃R'), un groupe nitro (-NO₂), et un groupe trifluorométhyle (-CF₃) ;
où R' est choisi dans l'ensemble constitué par un groupe alkyle en C₁ à C₆₀, un groupe aryle en C₆ à C₆₀ et un groupe hétérocyclique en C₁ à C₆₀ qui sont non substitués ou substitués par une amine, un amide, un éther ou un ester.

2. Dispositif d'affichage EL organique selon la revendication 1, dans lequel la couche de génération de charge comprend un premier matériau ayant un niveau énergétique orbital moléculaire non occupé minimal, dans lequel la couche d'injection de trous comprend un deuxième matériau ayant un niveau énergétique orbitaire moléculaire occupé maximal, et dans lequel une différence entre le niveau énergétique orbitaire moléculaire non occupé minimal du premier matériau et le niveau énergétique orbitaire moléculaire occupé maximal du deuxième matériau est située dans la plage allant d'environ -2 eV à environ +2 eV.

3. Dispositif d'affichage EL organique selon l'une quelconque des revendications précédentes, lequel dispositif comprend une pluralité de pixels, et dans lequel la couche de génération de charge forme une couche commune pour au moins deux des pixels.

4. Dispositif d'affichage EL organique selon l'une quelconque des revendications précédentes, dans lequel la couche de génération de charge a une épaisseur située dans la plage allant d'environ 1 nm (10 Å) à environ 20 nm (200 Å).

5. Dispositif d'affichage EL organique selon la revendication 4, dans lequel la couche de génération de charge a une épaisseur située dans la plage allant d'environ 2 nm (20 Å) à environ 8 nm (80 Å).

6. Dispositif d'affichage EL organique selon l'une quelconque des revendications précédentes, comprenant en outre au moins une couche choisie dans le groupe constitué par une couche de blocage de trous, une couche de transport d'électrons et une couche d'injection d'électrons, interposée entre la couche luminescente et la deuxième electrode

7. Dispositif d'affichage EL organique selon l'une quelconque des revendications précédentes, comprenant en outre une couche de transport d'électrons interposée entre la deuxième électrode et la couche luminescente.

8. Dispositif d'affichage EL organique selon l'une quelconque des revendications précédentes, comprenant en outre un substrat, dans lequel la première électrode est formée au-dessus du substrat.

9. Dispositif d'affichage EL organique selon la revendication 7 ou 8, comprenant en outre une couche d'injection d'électrons interposée entre la couche de transport d'électrons et la deuxième électrode.

10. Dispositif d'affichage EL organique selon l'une quelconque des revendications 7 et 9, comprenant en outre une couche de blocage de trous interposée entre la couche de transport d'électrons et la couche luminescente.

11. Dispositif électronique comprenant un dispositif d'affichage EL organique selon l'une quelconque des revendications précédentes.

12. Procédé de fabrication d'un dispositif d'affichage EL organique selon la revendication 1, lequel procédé comprend :
la formation d'une couche d'injection de trous au-dessus d'une première électrode ;
la formation d'une couche de génération de charge au-dessus de la couche d'injection de trous ; et
la formation d'une couche de transport de trous au-dessus de la couche de génération de charge.

13. Procédé selon la revendication 12, comprenant en outre :
la formation d'une couche luminescente au-dessus de la couche de transport de trous ; et
la formation d'une deuxième électrode au-dessus de la couche luminescente.

14. Procédé selon la revendication 13, comprenant en outre la formation d'au moins l'une parmi une couche de blocage de trous, une couche de transport d'électrons et une couche d'injection d'électrons après la formation de la couche luminescente et avant la formation de la deuxième électrode.

15. Procédé selon l'une quelconque des revendications 12 à 14, dans lequel la couche de génération de charge comprend un premier matériau ayant un niveau énergétique orbital moléculaire non occupé minimal, dans lequel la couche d'injection de trous comprend un deuxième matériau ayant un niveau énergétique orbitaire moléculaire occupé maximal, et dans lequel une différence entre le niveau énergétique orbitaire moléculaire non occupé minimal du premier matériau et le niveau énergétique orbitaire moléculaire occupé maximal du deuxième matériau est située dans la plage allant d'environ -2 eV à environ +2 eV.

16. Procédé selon l'une quelconque des revendications 12 à 15, dans lequel la formation de la couche de génération de charge comprend l'utilisation d'une déposition de vapeur par chauffage au moyen d'une résistance, d'une déposition de vapeur par faisceau d'électrons, d'une déposition de vapeur par faisceau laser ou d'une déposition par pulvérisation cathodique.

17. Procédé selon l'une quelconque des revendications 12 à 16, dans lequel la couche de génération de charge a une épaisseur située dans la plage allant d'environ 1 nm (10 Å) à environ 20 nm (200 Å).
